# EUROPEAN PATENT APPLICATION

(11) **EP 4 575 594 A1**
(43) Date of publication of application: **25.06.2025**
(21) Application number: 24206689.2
(22) Date of filing: 15.10.2024
(51) Int. Cl.: G02B 5/02, G02F 1/1335

(54) **DISPLAY DEVICE**

(30) Priority: 19.12.2023 KR 20230185366
(71) Applicant: LG Display Co., Ltd., Seoul 07336 (KR)
(72) Inventor: Han, JiSu, 10845 Gyeonggi-do (KR); Ji, YongSeok, 10845 Gyeonggi-do (KR)
(74) Representative: Ter Meer Steinmeister & Partner

(57) **Abstract**

Provided is a display device including an antiglare layer. The antiglare layer includes a base film, a first coating layer disposed over the base film and including a plurality of textured structures, a plurality of beads disposed inside the textured structures, and a second coating layer disposed over the first coating layer. The antiglare layer prevents sparkling.

## Description

This application claims priority from Korean Patent Application No. 10-2023-0185366, filed on December 19, 2023.

### BACKGROUND

### Field

Embodiments relate to a display device.

### Description of Related Art

In response to the development of the information society, demand for various types of display devices for displaying images is increasing. Recently, a range of display devices, such as liquid crystal display (LCD) devices and organic light-emitting display devices, have recently come into widespread use.

A display device may include an antiglare layer. The antiglare layer may scatter incident external light.

### BRIEF SUMMARY

Sparkling may occur on the antiglare layer. Sparkling may degrade the quality of the display panel.

Embodiments may provide a display device able to reduce image distortion.

Embodiments may provide a display device able to prevent sparkling.

Embodiments of the present disclosure may provide a display device able to equalize the heights of textured structures.

Embodiments may provide a high-quality display device having improved image quality due to the prevention of sparkling.

The object is solved by the features of the independent claims. Preferred embodiments are given in the dependent claims.

Embodiments of the present disclosure may provide a display device including: a display panel on which a plurality of subpixels are arranged; and an antiglare layer disposed over the display panel, wherein the antiglare layer includes: a base film; a first coating layer disposed over the base film and including a plurality of textured structures; a plurality of beads disposed inside the textured structures; and a second coating layer disposed over the first coating layer.

In one or more embodiments, an arithmetic mean height of the textured structures may be lower than a reference height.

In one or more embodiments, a height distribution of the textured structures may be 3 or less.

Preferably a maximum height of the textured structures may be greater than or equal to 2.0 micrometers.

In one or more embodiments, a diameter of the beads may be between greater between 0.8 micrometers and 3.5 micrometers.

In one or more embodiments, a first refractive index of the first coating layer, a second refractive index of the beads, and a third refractive index of the second coating layer may be the same.

In one or more embodiments, each of the first refractive index, the second refractive index, and the third refractive index may be between 1.49 and 1.65.

In one or more embodiments, the first refractive index of the first coating layer may be the same as the second refractive index of the plurality of beads.

In one or more embodiments, the second coating layer may include a first portion having a third refractive index that may be the same as the first refractive index, and a second portion having a fourth refractive index that may be smaller than the third refractive index.

In one or more embodiments, the plurality of textured structures of the first coating layer may penetrate the second coating layer.

In one or more embodiments, the height of the end portions of the plurality of textured structures of the first coating layer may be higher than the height of the upper surface of the second coating layer.

In one or more embodiments, the area of the upper surface of the second coating layer (may be wider than the area of the lower surface of the second coating layer.

In one or more embodiments, the shape of the plurality of uneven portions may be a cone shape.

In one or more embodiments, light emitted from a plurality of sub-pixels may be emitted to the outside through the plurality of beads included inside the plurality of uneven portions.

In one or more embodiments, the base film may comprise polyethylene terephthalate.

In one or more embodiments, the display device may further comprise a polarizing plate disposed between the display panel and the antiglare layer.

According to embodiments, the display device may reduce image distortion.

According to embodiments, the display device may prevent sparkling.

According to embodiments, the display device may equalize the heights of textured structures.

According to embodiments, the display device may be provided as a high-quality display device having improved image quality by preventing sparkling.

### DESCRIPTION OF DRAWINGS

The above and other objectives, features, and advantages of the present disclosure will be more clearly understood from the following detailed description, taken in conjunction with the accompanying drawings, in which:
FIG. 1 illustrates the system configuration of a display device according to embodiments;
FIG. 2 illustrates the display panel according to embodiments;
FIG. 3 schematically illustrates the display device according to embodiments;
FIG. 4 illustrates an antiglare film according to embodiments;
FIGS. 5 and 6 illustrate sparkling according to embodiments;
FIG. 7 illustrates an antiglare layer according to embodiments;
FIG. 8 is a graph illustrating heights of textured structures according to embodiments;
FIG. 9 illustrates experimental data regarding the heights of textured structures according to examples;
FIGS. 10, 11, and 12 illustrate experimental data regarding the heights of beads and textured structures according to examples;
FIG. 13 illustrates a table regarding refractive indices of antiglare layers according to examples; and
FIGS. 14 and 15 illustrate antiglare layers according to examples.

### DETAILED DESCRIPTION

In the following description of examples or embodiments of the present invention, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the present invention, detailed descriptions of well-known functions and components incorporated herein will be omitted when it is determined that the description may make the subject matter in some embodiments of the present invention rather unclear. The terms such as "including", "having", "containing", "constituting" "make up of', and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the present invention. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When time relative terms, such as "after", "subsequent to", "next", "before", and the like, are used to describe processes or operations of elements or configurations, or flows or steps in operating, processing, manufacturing methods, these terms may be used to describe non-consecutive or non-sequential processes or operations unless the term "directly" or "immediately" is used together.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

Hereinafter, a variety of embodiments will be described in detail with reference to the accompanying drawings.

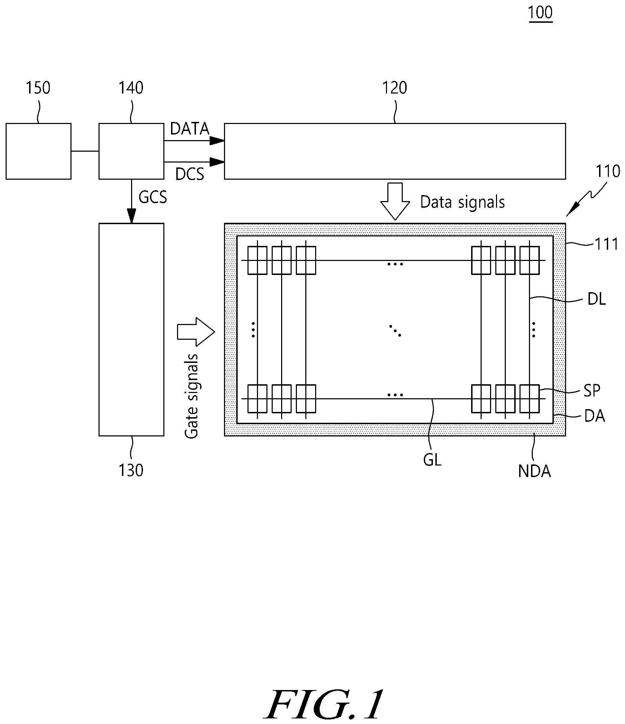

FIG. 1 illustrates the system configuration of a display device 100 according to embodiments.

Referring to FIG. 1, the display device 100 according to embodiments may include a display panel 110 and a display driving circuit as components for displaying images. The display driving circuit is circuitry for driving the display panel 110, and may include a data driver circuit 120, a gate driver circuit 130, a display controller 140, and the like.

The display panel 110 may include a substrate 111 and a plurality of subpixels SP disposed on the substrate 111.

The substrate 111 of the display panel 110 may include a display area DA on which images (or videos) may be displayed and a non-display area NDA located outside the display area DA.

The subpixels SP for displaying images may be provided in the display area DA, and the non-display area NDA may include a pad area PA located in a first direction from the display area DA.

In the display panel 110 according to embodiments, the non-display area NDA may have a significantly small size. As used herein, the non-display area NDA is also referred to as a "bezel".

For example, the non-display area NDA may include a first non-display area located outside the display area DA in the first direction, a second non-display area located outside the display area DA in a second direction intersecting the first direction, a third non-display area located outside the display area DA in a direction opposite to the first direction, and a fourth non-display area located outside the display area DA in a direction opposite to the second direction. One or two of the first to fourth non-display areas may include the pad area to which the data driver circuit 120 is connected or bonded. Two or three of the first to fourth non-display areas not including the pad area may have a significantly small size.

In another example, the boundary area between the display area DA and the non-display area NDA may be bent such that the non-display area NDA is located under the display area. In this case, when a user is viewing the display device 100 from the front, little or no portion of the non-display area NDA may be visible to the user.

On the substrate 111 of the display panel 110, various types of signal lines for driving the subpixels SP may be disposed.

The display device 100 according to embodiments may be a liquid crystal display (LCD) device, or may be a self-illuminating display device in which the display panel 110 is self-illuminating. When the display device 100 according to embodiments is a self-illuminating display device, each of the subpixels SP may include a light-emitting element.

For example, the display device 100 according to embodiments may be an organic light-emitting display device in which the light-emitting element is implemented as an organic light-emitting diode (OLED). In another example, the display device 100 according to embodiments may be an inorganic light-emitting display device in which the light-emitting element is implemented as an inorganic light-emitting diode (LED). In particular, the display device 100 may be a micro LED display device having a smaller light-emitting area for high quality and high resolution realization. In another example, the display device 100 according to embodiments may be a quantum dot display device in which the light-emitting element is implemented as a quantum dot, a self-emitting semiconductor crystal.

The structure of each of the subpixels SP may vary depending on the type of the display device 100. For example, when the display device 100 is a self-emitting display device in which the subpixels SP are self-luminous, each of the subpixels SP may include a self-emitting light-emitting element, one or more transistors, and one or more capacitors.

For example, various types of signal lines may include a plurality of data lines DL transferring data signals (also known as data voltages or image (or video) signals), a plurality of gate lines GL transferring gate signals (also known as scanning signals), and the like.

For example, the data lines DL and the gate lines GL may intersect each other. The respective data lines DL may be arranged to extend in the first direction, and the respective gate lines GL may be arranged to extend in the second direction. Here, the first direction may be a column direction, and the second direction may be a row direction. In another example, the first direction may be a row direction, and the second direction may be a column direction. In the following description, for the sake of brevity, an example in which the respective data lines DL are arranged in the column direction and the respective gate lines GL are arranged in the row direction is described.

The data driver circuit 120 is a circuit for driving the data lines DL, and may output data signals to the data lines DL.

The data driver circuit 120 may receive image data *DATA* in a digital format from the display controller 140, convert the received image data *DATA* into analog data signals, and output the converted analog data signals to the respective data lines DL.

For example, the data driver circuit 120 may be connected to the display panel 110 by a tape-automated bonding (TAB) method, connected to bonding pads on the display panel 110 by a chip-on-glass (COG) or chip-on-panel (COP) method, or implemented with a chip-on-film (COF) method to be connected to the display panel 110.

The data driver circuit 120 may be connected to one side (e.g., the top or bottom portion) of the display panel 110. In another example, the data driver circuit 120 may be connected to both sides (e.g., both the top and bottom portions) of the display panel 110 or to two or more sides of the four sides of the display panel 110, depending on the driving method, the design of the display panel, or the like.

The data driver circuit 120 may be connected to the periphery of the display area DA of the display panel 110, but in another example, may be disposed in the display area DA of the display panel 110.

The gate driver circuit 130 is a circuit for driving the gate lines GL, and may output gate signals to the gate lines GL.

The gate driver circuit 130 may be supplied with a first gate voltage corresponding to a turn-on level voltage and a second gate voltage corresponding to a turn-off level voltage along with various gate driving control signals GCS to generate gate signals, and may supply the generated gate signals to the gate lines GL.

In the display device 100 according to embodiments, the gate driver circuit 130 may be mounted inside the display panel 110 by a gate-in-panel (GIP) method. When the gate driver circuit 130 is a gate-in-panel circuit, the gate driver circuit 130 may be provided over the substrate 111 of the display panel 110 during the manufacturing process of the display panel 110.

In display device 100 according to embodiments, the gate driver circuit 130 may be disposed in the display area DA of the display panel 110. For example, the gate driver circuit 130 may be disposed in a first portion of the display area DA (e.g., a left portion or a right portion of the display area DA). In another example, the gate driver circuit 130 may be disposed in a first portion of the display area DA (e.g., a left portion or a right portion within the display area DA) and a second portion of the display area DA (e.g., a right portion or a left portion within the display area DA).

In the present disclosure, the gate driver circuit 130 mounted inside the display panel 110 by the GIP method is referred to as a "GIP circuit".

The display controller 140 is a device for controlling the data driver circuit 120 and the gate driver circuit 130, and may control the driving timing for the data lines DL and the driving timing for the gate lines GL.

The display controller 140 may supply a data driving control signal DCS to the data driver circuit 120 to control the data driver circuit 120 and a gate driving control signal GCS to the gate driver circuit 130 to control the gate driver circuit 130.

The display controller 140 may receive input image data from the host system 150, and may supply image data *DATA* to the data driver circuit 120 based on the input image data.

The display controller 140 may be implemented as a separate component from the data driver circuit 120, or may be integrated with the data driver circuit 120 to form an integrated circuit.

The display controller 140 may be a timing controller used in conventional display technology, may be a control device that may include a timing controller to further perform other control functions, may be a control device other than a timing controller, or may be a circuit within a control device. The display controller 140 may be implemented as a variety of circuits or electronic components, such as an integrated circuit (IC), a field programmable gate array (FPGA), an application specific integrated circuit (ASIC), or a processor.

The display controller 140 may be mounted on a printed circuit board (PCB), a flexible printed circuit (FPC), or the like, and may be electrically connected to the data driver circuit 120 and the gate driver circuit 130 through the PCB, the FPC, or the like.

The display controller 140 may transmit and receive signals to and from the data driver circuit 120 according to one or more predetermined interfaces. For example, the interface may include a low voltage differential signaling (LVDS) interface, an embedded clock point-point interface (EPI) interface, a serial peripheral interface (SPI), and the like.

To further provide a touch sensing function in addition to an image displaying function, the display device 100 according to embodiments may include a touch sensor and a touch sensing circuit for detecting whether a touch is caused by a touch object, such as a finger or a pen (e.g., a stylus), or for determining a touch position by sensing the touch sensor.

The touch sensing circuit may include a touch driver circuit to drive and sense the touch sensor to generate and output touch sensing data and a touch controller to detect a touch occurrence or determine a touch position using the touch sensing data.

The touch sensor may include a plurality of touch electrodes. The ouch sensor may further include a plurality of touch lines for electrically coupling the plurality of touch electrodes to the touch driver circuit.

The touch sensor may be present either outside the display panel 110 in the form of a touch panel or inside the display panel 110. When the touch sensor is in the form of a touch panel external to the display panel 110, the touch sensor is referred to as an add-on touch sensor. When the touch sensor is an add-on touch sensor, the touch panel and the display panel 110 may be fabricated separately and fitted together during assembly. Such an add-on touch panel may include a substrate for the touch panel and a plurality of touch electrodes on the substrate for the touch panel.

When the touch sensor is present inside the display panel 110, the touch sensor may be provided on the substrate during the fabrication process of the display panel 110, along with signal lines and electrodes associated with display driving.

The touch driver circuit may supply a touch driving signal to at least one of the touch electrodes, and may sense at least one of the touch electrodes to generate touch sensing data.

The touch sensing circuit may perform touch sensing in a self-capacitance sensing manner or a mutual-capacitance sensing manner.

When the touch circuit performs touch sensing in the self-capacitance sensing manner, the touch circuit may perform touch sensing based on the capacitance between each touch electrode and a touch object (e.g., a finger or a pen (e.g., a stylus)). According to the self-capacitance sensing, each of the touch electrodes may act as both a driving touch electrode and a sensing touch electrode. The touch driver circuit may drive all or some of the touch electrodes and sense all or some of the touch electrodes.

When the touch circuit performs touch sensing in the mutual capacitance sensing manner, the touch circuit may perform touch sensing based on the capacitance between the touch electrodes. According to the mutual capacitance sensing, the touch electrodes are divided into driving touch electrodes and sensing touch electrodes. The touch driver circuit may drive the driving touch electrodes and sense the sensing touch electrodes.

The touch driver circuit and the touch controller of the touch sensing circuit may be implemented as separate devices or as a single device. In addition, the touch driver circuit and the data driver circuit may be implemented as separate devices or as a single device.

The display device 100 may further include a power supply circuit for supplying various power to the display driving circuit and/or the touch sensing circuit, and the like.

The display device 100 according to embodiments may be, but is not limited to, a mobile device, such as a smartphone or a tablet, or a monitor of various sizes, a television set (TV), or the like, and may be any display of various types and various sizes capable of displaying information or images (or videos).

The display device 100 according to embodiments may further include electronic devices such as a camera (or image sensor) and a detection sensor. For example, a detection sensor may be a sensor that receives light, such as infrared, ultrasonic, or ultraviolet light, to detect an object or a human body.

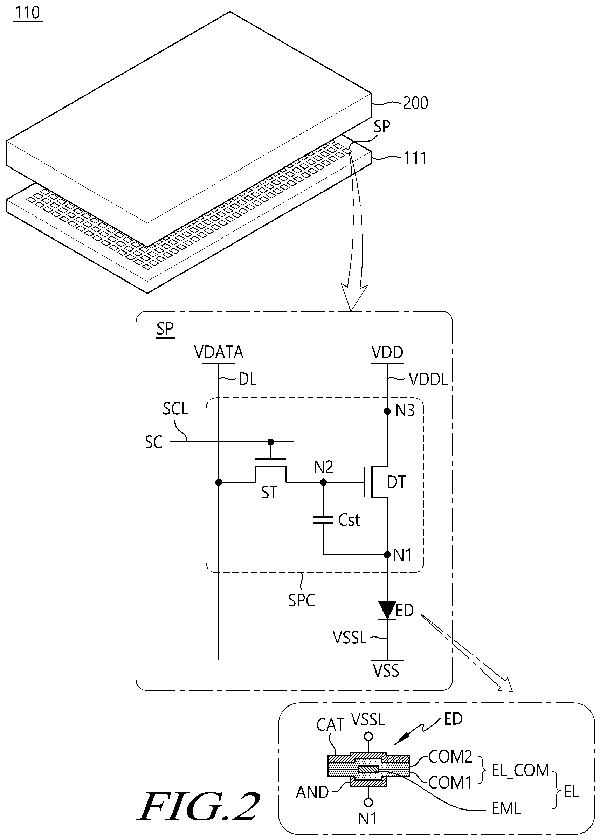

FIG. 2 illustrates the display panel 110 according to embodiments.

Referring to FIG. 2, the display panel 110 may include a substrate 111 on which a plurality of subpixels SP are disposed and an encapsulation layer 200 over the substrate 111. Here, the encapsulation layer 200 may also be referred to as an encapsulation substrate, encapsulation portion, or the like.

Referring to FIG. 2, when the display device 100 according to embodiments is a self-emitting light-emitting display, each of the subpixels SP disposed on the substrate 111 may include a light-emitting element ED and a subpixel circuit SPC for driving the light-emitting element ED.

Referring to FIG. 2, the subpixel circuit SPC may include a plurality of pixel driving transistors and at least one capacitor for driving the light-emitting element ED. In the present disclosure, the subpixel circuit SPC may drive the light-emitting element ED by supplying a driving current to the light-emitting element ED at predetermined timing. The light-emitting element ED may be driven by the driving current to emit light.

The pixel driving transistors may include a driving transistor DT for driving the light-emitting element ED and a scanning transistor ST that is turned on or off in response to a scanning signal SC.

The driving transistor DT may supply driving current to the light-emitting element ED.

The scanning transistor ST may be configured to control the electrical state of a corresponding node in the subpixel circuit SPC or to control the state or operation of the driving transistor DT.

The at least one capacitor may include a storage capacitor Cst for maintaining a constant voltage during a frame.

To drive the subpixel SP, a data signal VDATA, an image signal, and a scanning signal SC, a gate signal, and the like may be applied to the subpixel SP. In addition, to drive the subpixel SP, a common pixel driving voltage including a first common driving voltage VDD and a second common driving voltage VSS may be applied to the subpixel SP.

The light-emitting element ED may include an anode AND, a light-emitting element interlayer EL, and a cathode CAT. The light-emitting element interlayer EL may be disposed between the anode AND and the cathode CAT.

When the light-emitting element ED is an organic light-emitting element, the light-emitting element interlayer EL may include an emission layer EML, a first common interlayer COM1 between the anode AND and the emission layer EML, and a second common interlayer COM2 between the emission layer EML and the cathode. The emission layer EML may be disposed in every subpixel SP. In comparison, the first common interlayer COM1 and the second common interlayer COM2 may be provided in common across two or more subpixels among the plurality of subpixels SP. The emission layer EML may be disposed in each emission area, and the first common intermediate layer COM1 and the second common intermediate layer COM2 may be disposed in common across a plurality of emission and non-emission areas. The first common intermediate layer COM1 and the second common intermediate layer COM2 are collectively referred to as a common intermediate layer EL_COM.

For example, the first common interlayer COM1 may include a hole injection layer HIL, a hole transfer layer HTL, and the like. The second common intermediate layer COM2 may include an electron transfer layer ETL, an electron injection layer EIL, and the like. The hole injection layer may inject holes from the anode AND into the hole transfer layer, the hole transfer layer may transfer holes to the emission layer EML, the electron injection layer may inject electrons from the cathode CAT into the electron transfer layer, and the electron transfer layer may transfer electrons to the emission layer EML.

For example, the cathode CAT may be electrically connected to a second common driving voltage line VSSL. The second common driving voltage VSS, a type of common pixel driving voltage, may be applied to the cathode CAT through the second common driving voltage line VSSL. The anode AND may be electrically connected to the first node N1 of the driving transistor DT of each of the subpixels SP. In the present disclosure, the second common driving voltage VSS may also be referred to as the base voltage VSS, and the second common driving voltage line VSSL may also be referred to as the base voltage line VSSL.

For example, the anode AND may be a pixel electrode disposed in each of the subpixels SP, and the cathode CAT may be a common electrode disposed in common in the subpixels SP. In another example, the cathode CAT may be a pixel electrode disposed in each of the subpixels SP, and the anode AND may be a common electrode disposed in common in the subpixels SP. In the following description, for the sake of brevity, a case in which the anode AND is a pixel electrode and the cathode CAT is a common electrode is considered.

Each light-emitting element ED may be a portion in which an anode AND, a light-emitting element interlayer EL, and a cathode CAT overlap. Each light-emitting element ED may form an emission area. For example, the emission area of each light-emitting element ED may include an area where the anode AND, the light-emitting element interlayer EL, and the cathode CAT overlap.

For example, the light-emitting element ED may be an organic light-emitting diode (OLED), an inorganic-based light-emitting diode (LED), a quantum dot light-emitting element, or the like. For example, when the light-emitting element ED is an OLED, the light-emitting element interlayer EL in the light-emitting element ED may include an organic light-emitting element interlayer EL.

The driving transistor DT may be a driving transistor for supplying the driving current to the light-emitting element ED. The driving transistor DT may be connected to a first common driving voltage line VDDL and to the light-emitting element ED.

The driving transistor DT may include a first node N1 electrically connected to the light-emitting element ED, a second node N2 to which the data signal VDATA may be applied, and a third node N3 to which the driving voltage VDD is applied from the driving voltage line DVL.

In the driving transistor DT, the second node N2 may be a gate node, the first node N1 may be a source node or a drain node, and the third node N3 may be a drain node or a source node. In the following description, for the sake of brevity, an example in which the second node N2 may be a gate node, the first node N1 may be a source node, and the third node N3 may be a drain node in the driving transistor DT is considered.

The scanning transistor ST included in the subpixel circuit SPC illustrated in FIG. 2 may be a switching transistor for transferring the data signal VDATA, an image signal, to the second node N2, which is the gate node of the driving transistor DT.

The scanning transistor ST may be on/off-controlled by the scanning signal SC, a gate signal, applied through a scan line SCL, a type of gate line GL, to control an electrical connection between the second node N2 of the driving transistor DT and the data line DL. The drain electrode or the source electrode of the scanning transistor ST may be electrically connected to the data line DL, the source electrode or the drain electrode of the scanning transistor ST may be electrically connected to the second node N2 of the driving transistor DT, and the gate electrode of the scanning transistor ST may be electrically connected to the scan line SCL.

The storage capacitor Cst may be electrically connected to the first node N1 and the first node N2 of the driving transistor DT. The storage capacitor Cst may include a first capacitor electrode electrically connected to the first node N1 of the driving transistor DT or corresponding to the first node N1 of the driving transistor DT and a second capacitor electrode electrically connected to the second node N2 of the driving transistor DT or corresponding to the second node N2 of the driving transistor DT.

The storage capacitor Cst may be an external capacitor intentionally designed to be outside of the driving transistor DT, rather than being a parasitic capacitor (e.g., Cgs or Cgd), which is an internal capacitor present between the first node N1 and the second node N2 of the driving transistor DT.

Each of the driving transistor DT and the scanning transistor ST may be an n-type transistor or a p-type transistor.

The display panel 110 may have a top emission structure or a bottom emission structure.

When the display panel 110 has the top emission structure, at least a portion of the subpixel circuit SPC may overlap at least a portion of the light-emitting element ED in the vertical direction. In contrast, when the display panel 110 has the bottom emission structure, the subpixel circuit SPC may not overlap the light-emitting element ED in the vertical direction.

The subpixel circuit SPC may have a 2T1C structure including two (2) transistors DT and ST and one (1) capacitor Cst as shown in FIG. 2, and in some situations, may include one or more transistors and/or one or more capacitors.

For example, the subpixel circuit SPC may have an 8T1C structure including eight (8) transistors and one (1) capacitor. In another example, the subpixel circuit SPC may have a 6T2C structure including six (6) transistors and two (2) capacitors. In another example, the subpixel circuit SPC may have a 7T1C structure including seven (7) transistors and one (1) capacitor.

The type and number of gate lines for gate signals supplied to the subpixels SP may vary depending on the structure of the subpixel circuit SPC.

In addition, the type and number of common pixel driving voltages supplied to subpixels SP may vary depending on the structure of the subpixel circuit SPC.

Since the circuit elements (in particular, the light-emitting element ED implemented as an OLED in each of the subpixels SP including an organic material) are susceptible to external moisture or oxygen, the encapsulation layer 200 may be disposed on the display panel 110 to prevent external moisture or oxygen from penetrating the circuit elements (in particular, the light-emitting element ED). The encapsulation layer 200 may be configured in various forms to prevent the light-emitting element ED from coming into contact with moisture or oxygen.

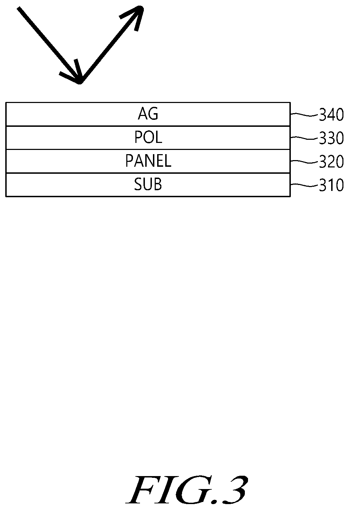

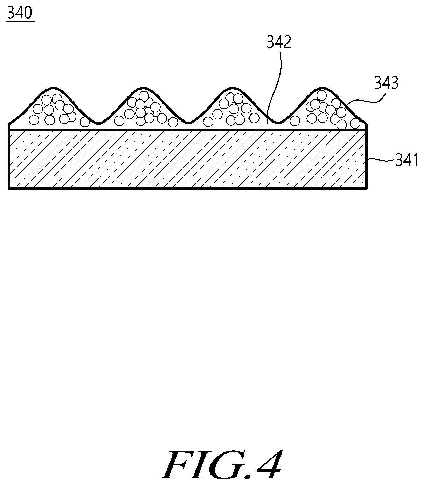

FIG. 3 schematically illustrates the display device 100 according to embodiments. FIG. 4 illustrates an antiglare film 340 according to embodiments.

Referring to FIG. 3, the display device 100 may include a substrate 310, an image display layer 320, a polarizer 330, and an antiglare film 340.

The image display layer 320 may be disposed over the substrate 310. The image display layer 320 may include a plurality of sub-pixels.

The polarizer 330 may be disposed over the image display layer 320. The polarizer 330 may filter external light so as not to be reflected back to the user.

The antiglare film 340 may be disposed over the polarizer 330. The antiglare film 340 may scatter external light. Accordingly, the antiglare film 340 may prevent external light from being reflected back to the user.

The antiglare film 340 may include a base film 341, a coating layer 342, and a plurality of beads 343.

The base film 341 may be disposed on the lowermost portion of the antiglare film 340. The base film 341 may be a plastic film. The base film 341 may be transparent.

For example, the base film 341 may include one selected from among triacetyl cellulose (TAC), polyester (TPEE), polyethylene terephthalate (PET), polyimide (PI), polyamide (PA), aramid, polyethylene (PE), polyacrylate (PAR), polyether sulfone, polysulfone, polypropylene (PP), diacetyl cellulose, polyvinyl chloride, acrylic resin (PMMA), polycarbonate (PC), epoxy resin, urea resin, urethane resin, melamine resin, or the like.

The coating layer 342 may be disposed over the base film 341. The coating layer 342 may include a light stabilizer, an UV absorber, an antistatic agent, a flame retardant, an antioxidant, and the like.

The beads 343 may be included inside the coating layer 342. Since the beads 343 may be included inside the coating layer 342, the coating layer 342 may be in the form of a layer having protrusions. The protrusions may be in the shape of fine or microscopic textured structures or concave-convex structures.

The coating layer 342 may include the beads 343, and thus may include flat portions in which no beads are contained and protruding portions in which beads are contained.

External light incident on the beads may be scattered. As a result, external light incident on the display device 100 may not reach the user. That is, the antiglare film 340 may prevent degradation of visibility due to external light.

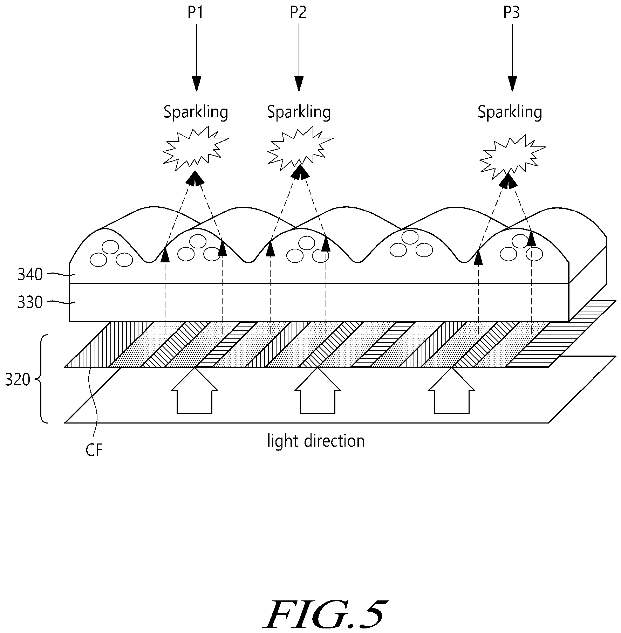

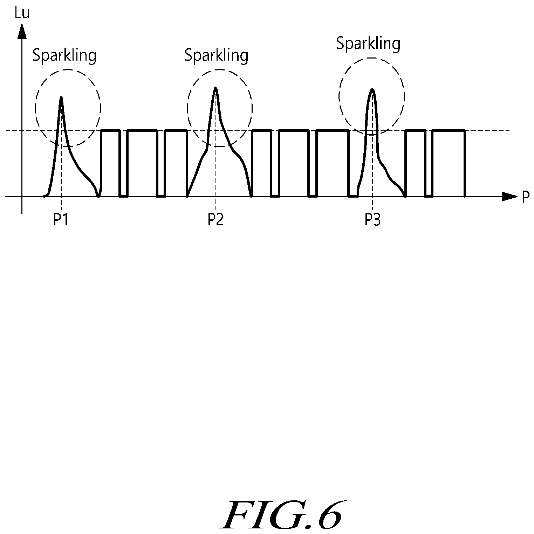

FIGS. 5 and 6 illustrate sparkling according to embodiments.

Referring to FIG. 5, the image display layer 320, the polarizer 330, and the antiglare film 340 are shown.

The image display layer 320 may emit image light in an upward direction. The image light may pass through a color filter.

After passing through the image display layer 320, the image light may pass through the polarizer 330 and reach the antiglare film 340.

Upon reaching the antiglare film 340, the direction of the image light may be bent by the beads 343.

In this case, as the refracted beams of image light pass through the antiglare film 340 and intersect each other, the antiglare film 340 may act as a lens. That is, a lensing phenomenon may occur.

In particular, when the effect of the lensing phenomenon caused by the antiglare film 340 is greater than the scattering effect caused thereby, sparkling points may appear. As the resolution of the image display layer 320 becomes increasingly higher and thus the size of the subpixel SP decreases, such sparkling may be perceived as a stronger indication of the lensing function in internal transmission light when the scattering effect by the beads 343 in the antiglare film 340 is not uniform with respect to the size of the subpixel SP.

Referring to FIG. 6, a graph of luminances Lu as a function of position P is shown.

Most of the luminances Lu according to positions P may equal to a predetermined reference luminance Lu.

However, sparkling may occur at a first position P1, a second position P2, and a third position P3. The luminances Lu of the sparkling portions may be relatively high.

In particular, this phenomenon may be more prominent when a plurality of subpixels are micro-LEDs.

Accordingly, embodiments may provide a display device 100 able to reduce image distortion.

Embodiments may provide a display device 100 able to preventing sparkling.

Embodiments may provide a display device 100 able to equalize the heights of textured structures.

Embodiments may provide a display device 100 able to operate at low power due to the prevention of sparkling.

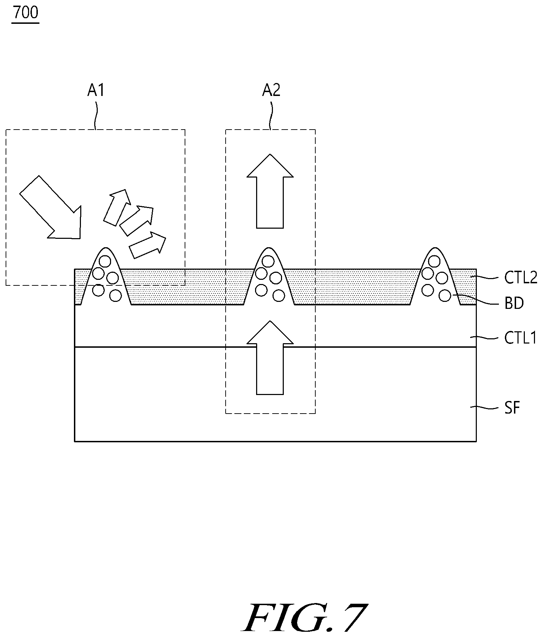

FIG. 7 illustrates an antiglare layer 700 according to embodiments.

Referring to FIG. 7, the antiglare layer 700 may include a base film SF, a first coating layer CTL1, a plurality of beads BD, and a second coating layer CTL2.

The base film SF may be disposed on the lowermost portion of the antiglare layer 700.

The first coating layer CTL1 is disposed over the base film SF and may include a plurality of fine or microscopic textured structures. The first coating layer CTL1 may include acrylic or the like.

A plurality of beads BD may be disposed inside the textured structures. The first coating layer CTL1 may include the beads BD. The beads BD may be silica beads. The beads BD may be silica particles, polyacrylic resin, or polystyrene resin.

The beads BD may be in the form of spheres or balls.

The portion of the first coating layer CTL1 containing the beads BD may convexly protrude in the form of textured structures. That is, the first coating layer CTL1 may include a plurality of textured structures. The textured structures may have curved valleys and curved tips in a regular order.

Each of the textured structures of the first coating layer CTL1 may include two or more beads BD. Referring to FIG. 7, each of the textured structures includes five beads BD, but the number of the beads may be less than or greater than five.

The portions of the first coating layer CTL1 including the BD is passing through the second coating layer CTL2.

The first coating layer CTL1 has a higher thickness than the second coating layer CTL2. IN particular the first coating layer CTL1 has a higher base thickness (without the portions including the beads BD) as the second coating layer CTL2.

External light may be scattered by the beads BD. External light may be incident on the beads BD and scattered into a plurality of light beams.

Referring to FIG. 7, it can be seen that a plurality of beads BDs are disposed in a first area A1. It can be seen that external light is scattered by the beads BD.

The second coating layer CTL2 may be disposed over the first coating layer CTL1. The second coating layer CTL2 may include acrylic or the like.

The second coating layer CTL2 may be disposed over between the portions including the beads BD.

The second coating layer CTL2 may be disposed over the first coating layer CTL1 but may not cover the entirety of the first coating layer CTL1.

The second coating layer CTL2 may be disposed between the textured structures of the first coating layer CTL1.

An image display layer (not shown) may be disposed under the antiglare layer 700. The image display layer (not shown) may emit imaging light toward the antiglare layer 700.

Since the second coating layer CTL2 may be disposed between the textured structures of the first coating layer CTL1, the sparkling caused by the imaging light may be prevented.

Referring to FIG. 7, the second coating layer CTL2 disposed in the second region A2 are shown. When the imaging light is emitted, the imaging light may not be scattered. That is, since the second coating layer CTL2 is disposed between the textured structures of the first coating layer CTL1, the imaging light may not be distorted.

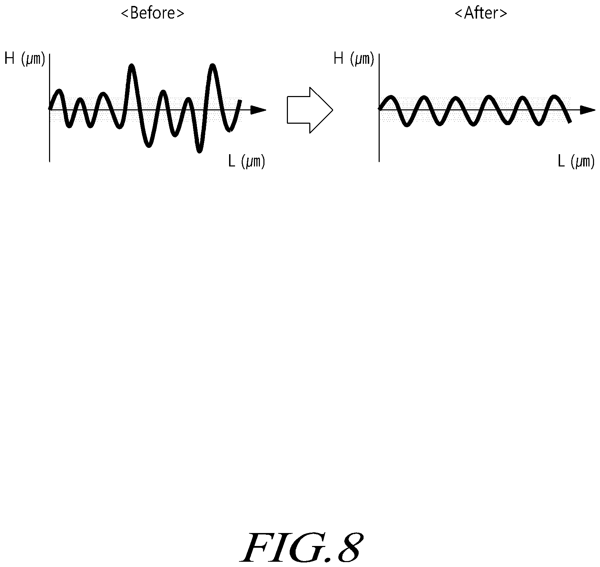

FIG. 8 is a graph illustrating heights of textured structures according to embodiments.

Referring to FIG. 8, graphs for a case in which the second coating layer CTL2 is not disposed between textured structures of the first coating layer CTL1 (Before) and a case in which the second coating layer CTL2 is disposed between textured structures of the first coating layer CTL1 (After) are shown.

When the second coating layer CTL2 is not disposed between the textured structures of the first coating layer CTL1 (Before), it can be seen that the heights of the textured structures are somewhat irregular.

When the second coating layer CTL2 is disposed between the textured structures of the first coating layer CTL1 (After), it can be seen that the heights of the textured structures are similar to each other.

Because the heights of the textured structures are similar to each other, sparkling that would otherwise be caused by imaging light may be prevented.

In the following, the heights of a plurality of textured structures will be discussed in more detail.

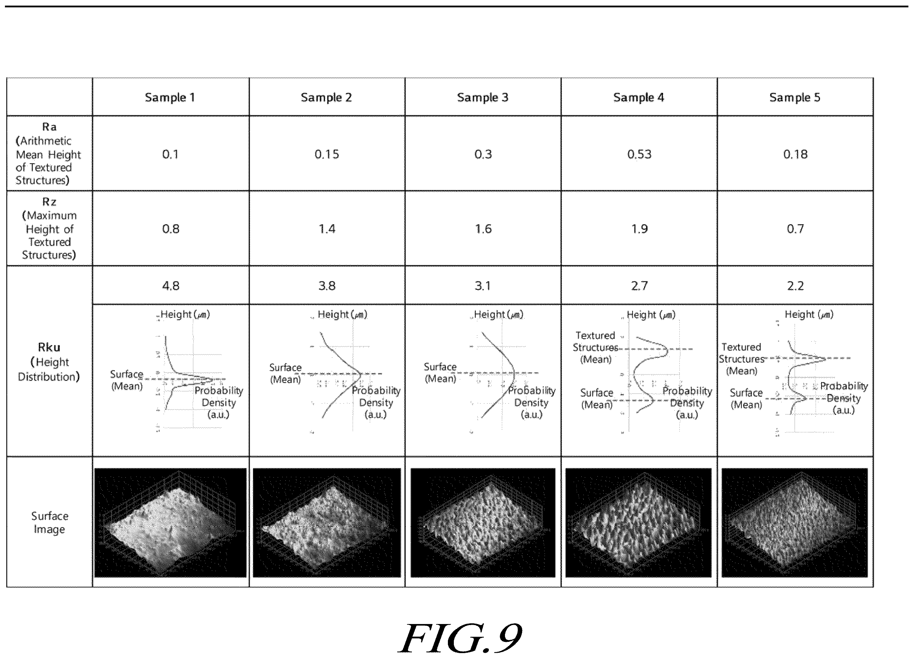

FIG. 9 illustrates experimental data regarding the heights of textured structures according to examples.

Referring to FIG. 9, the experimental data may include five samples.

Each of samples may include the arithmetic mean height Ra, the maximum height Rz, the height distribution Rku, and surface photograph data of textured structures. The arithmetic mean height Ra, the maximum height Rz, and the height distribution Rku of the textured structures are in micrometers.

Referring to FIG. 9, the surface photograph data shows a plurality of textured structures. The respective textured structures may have different heights. The height of each of the textured structures means the distance between the high point and the low point of the textured structure.

To evaluate data from a plurality of textured structures, concepts such as a minimum value, a maximum value, a mean value, an arithmetic mean height, a maximum height, and the height distribution of textured structures may be used.

The minimum value means the lowest value among the low points of the textured structures.

The maximum value means the highest value among the high points of the textured structures.

The mean value means the sum of all of the high points of the textured structures divided by the number of the textured structures. A height from the mean value to the low or high point may be referred to as an absolute height value.

The arithmetic mean height Ra of textured structures means the absolute height value integrated by the number of samples and then divided by the number of samples. The arithmetic mean height Ra of textured structures may also be referred to as a centerline mean of roughness, an arithmetic mean, a centerline mean, or the like.

The maximum height Rz means the mean of the absolute values of the five highest values among the high points and the five lowest values among the low points with respect to the mean value. The maximum height Rz may be referred to as a 10-point mean of roughness, or the like.

The height distribution Rku represents the distribution of the heights with respect to the mean value. When the height distribution Rku is closer to 3, the distribution of the heights is interpreted as being closer to a normal distribution. When the height distribution Rku is greater than 3, the distribution of the heights is interpreted as flat. When the height distribution Rku is less than 3, the distribution of the heights is interpreted as consisting of constant heights of textured structures. The height distribution Rku may be referred to as kurtosis.

The arithmetic mean height Ra, the maximum height Rz, the height distribution Rku, and the like of the textured structures may be referred to as parameters. The above-described parameters correspond to ISO 4287 defined by the International Organization for Standardization.

The arithmetic mean height Ra of textured structures may be lower than a predetermined reference height.

When the height distribution Rku of the textured structures is 3 or less, the height distribution Rku of the textured structures may be determined to be uniform.

In a first sample, Sample 1, the textured structures have an arithmetic mean height Ra of 0.1, a maximum height Rz of 0.8, and a height distribution Rku of 4.8. In this case, referring to the height distribution Rku and the surface photograph data, it can be seen that the heights of the textured structures are generally flat.

In a second sample, Sample 2, the textured structures have an arithmetic mean height Ra of 0.15, a maximum height Rz of 1.4, and a height distribution Rku of 3.8. In this case, referring to the height distribution Rku and the surface photograph data, it can be seen that the textured structures are a little higher.

In a third sample, Sample 3, the textured structures have an arithmetic mean height Ra of 0.3, a maximum height Rz of 1.6, and a height distribution Rku of 3.1. In this case, referring to the height distribution Rku and the surface photograph data, it can be seen that the height deviation of the textured structures is increased.

In a fourth sample, Sample 4, the textured structures have an arithmetic mean height Ra of 0.53, a maximum height Rz of 1.9, and a height distribution Rku of 2.7. In this case, referring to the height distribution Rku and the surface photograph data, it can be seen that the heights of the textured structures are uniform.

In a fifth sample, Sample 5, the textured structures have an arithmetic mean height Ra of 0.18, a maximum height Rz of 0.7, and a height distribution Rku of 2.2. In this case, referring to the height distribution Rku and the surface photograph data, it can be seen that the heights of the textured structures are more uniform than those of Sample 4.

The height distribution Rku of the textured structures may be set to be 3 or less by setting the arithmetic mean height Ra and the maximum height Rz of the textured structures. In this case, the maximum height of the textured structures may be greater than or equal to 2.0.

That is, the height distribution Rku of the textured structures of the antiglare layer 700 may be 3 or less. The maximum height of the textured structures of the antiglare layer 700 may be 2.0 or less.

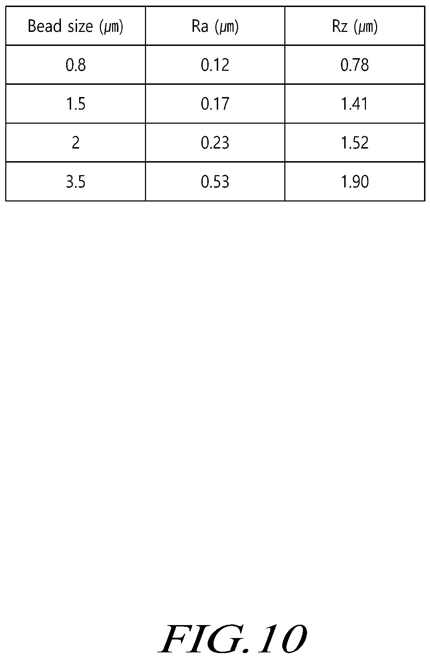

FIGS. 10, 11, and 12 illustrate experimental data regarding the heights of a plurality of beads BD and textured structures according to examples.

Referring to FIG. 10, experimental data for the bead size, the arithmetic mean height Ra of textured structures, and the maximum height Rz of textured structures are shown. These are the experimental data of the arithmetic mean height Ra and the maximum height Rz of textured structures according to the bead size.

The diameter of each of the beads BD may be greater than or equal to 0.8 and less than or equal to 3.5. By setting the diameter of the beads to be greater than or equal to 0.8 and less than or equal to 3.5, the height distribution Rku of the textured structures of the antiglare layer 700 may be set to be less than or equal to 3.

When the bead size is 0.8, the arithmetic mean height Ra of textured structures is 0.12, and the maximum height Rz of textured structures is 0.78.

When the bead size is 1.5, the arithmetic mean height Ra of textured structures is 0.17, and the maximum height Rz of textured structures is 1.41.

When the bead size is 2, the arithmetic mean height Ra of textured structures is 0.23, and the maximum height Rz of textured structures is 1.52.

When the bead size is 3.5, the arithmetic mean height Ra of textured structures is 0.53, and the maximum height Rz of textured structures is 1.90.

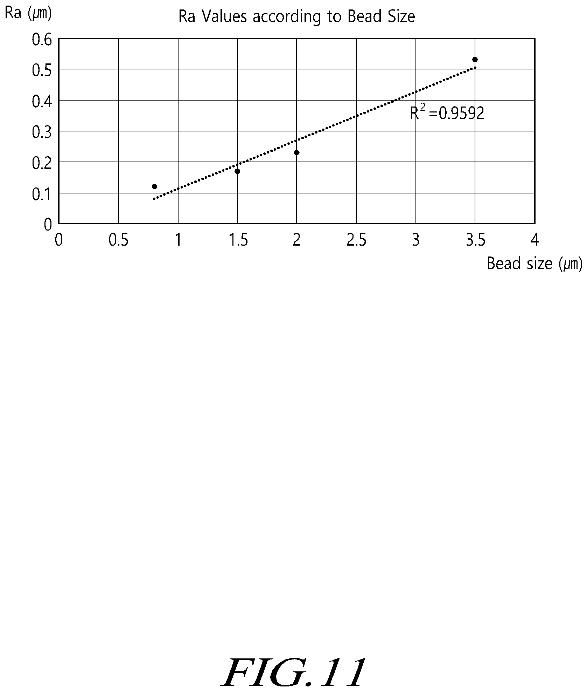

Referring to FIG. 11, the arithmetic mean heights Ra of textured structures according to the bead size are shown. The coefficient of determination R2 of regression analysis is 0.9592. That is, the arithmetic mean heights Ra of textured structures may be estimated by controlling the bead size.

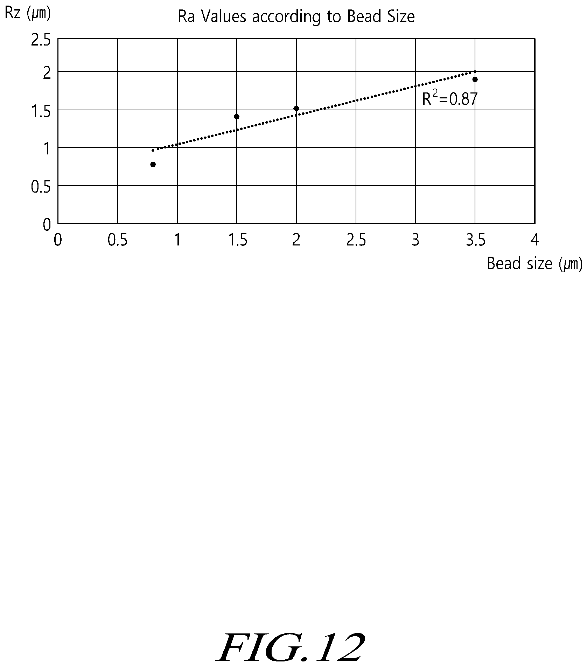

Referring to FIG. 12, the maximum height Rz of textured structures according to the bead size are shown. The coefficient of determination R2 of regression analysis is 0.87. That is, the maximum heights Rz of textured structures may be estimated by adjusting the bead size.

In other words, the bead size may be a major factor in increasing the height of textured structures.

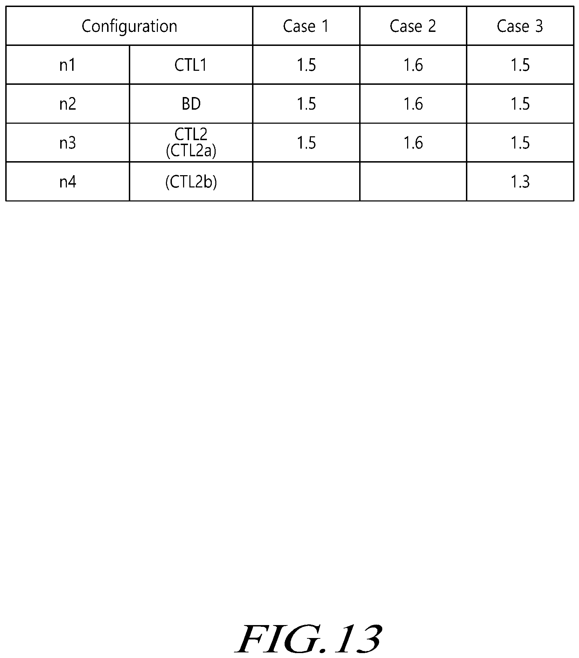

FIG. 13 illustrates a table regarding refractive indices of antiglare layers 700 according to examples.

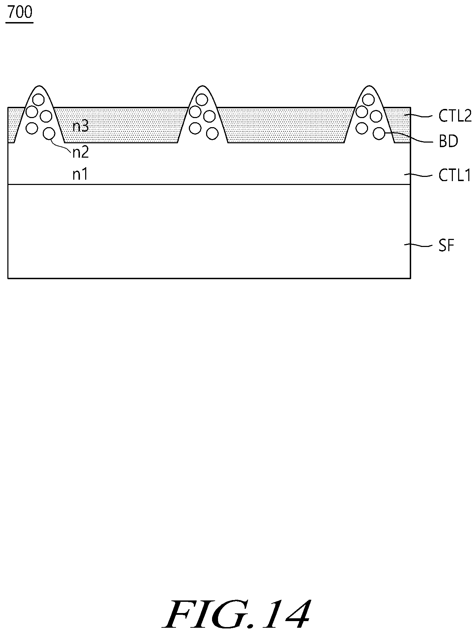

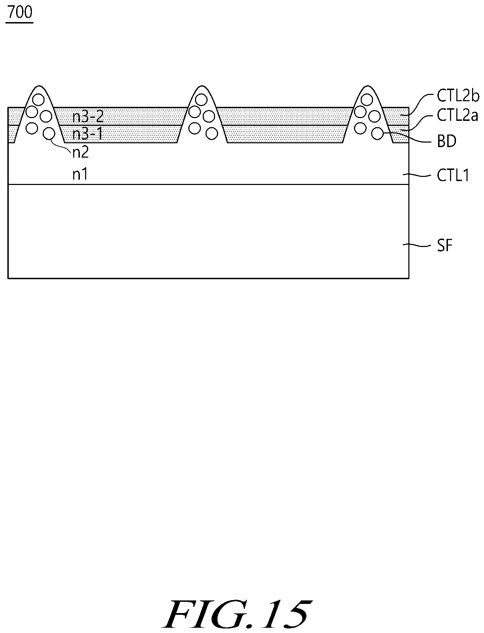

FIGS. 14 and 15 illustrate antiglare layers 700 according to examples.

Referring to FIG. 13, refractive index data of the antiglare layers 700 are shown.

The refractive indices of the antiglare layer 700 may include a first refractive index n1 of the first coating layer CTL1, a second refractive index n2 of the beads BD, and a third refractive index n3 of the second coating layer CTL2.

Referring to FIG. 13, the first refractive index n1 of the first coating layer CTL1, the second refractive index n2 of the beads BD, and the third refractive index n3 of the second coating layer CTL2 may be the same.

Each of the first refractive index n1, the second refractive index n2, and the third refractive index n3 may be between 1.49 and 1.65. Each of the first refractive index n1, the second refractive index n2, and the third refractive index n3 may be 1.5. Data obtained by dividing the refractive index into the three cases are described as an example.

In a first experimental example, Case 1, each of the first refractive index n1, the second refractive index n2, and the third refractive index n3 may be 1.5. Because the second coating layer CTL2 is disposed between the textured structures of the first coating layer CTL1 and the refractive indices are the same, sparkling that would otherwise be caused by imaging light may be prevented. The antiglare layer 700, to which the first refractive index n1, the second refractive index n2, and the third refractive index n3 described above are applied, is shown in FIG. 14.

In a second experimental example, Case 2, each of the first refractive index n1, the second refractive index n2, and the third refractive index n3 may be 1.6. The base film SF may be polyethylene terephthalate (PET). The antiglare layer 700, to which the first refractive index n1, the second refractive index n2, and the third refractive index n3 described above are applied, is shown in FIG. 14.

In a third experimental example, Case 3, each of the first refractive index n1 and the second refractive index n2 may be 1.5. The refractive index n3 of a first portion CTL2a of the second coating layer CTL2 may be 1.5, and the refractive index n4 of a second portion CTL2b of the second coating layer CTL2 may be 1.3. The antiglare layer 700, to which the first refractive index n1, the second refractive index n2, the refractive index n3 of the first portion CTL2a, and the refractive index n4 of the second portion CTL2b described above are applied, is shown in FIG. 15. Referring to FIG. 15, the second coating layer CTL2 may include the first portion CTL2a and the second portion CTL2b overlying the first portion CTL2a. The second coating layer CTL2 may include the first portion CTL2a and the second portion CTL2b by two coating processes. Since the second coating layer CTL2 includes the first portion CTL2a and the second portion CTL2b, a low reflection function may further be obtained.

The above-described embodiments of the present disclosure are briefly reviewed as follows.

Embodiments may provide a display device including: a display panel on which a plurality of subpixels are arranged; and an antiglare layer disposed over the display panel, wherein the antiglare layer includes: a base film; a first coating layer disposed over the base film and including a plurality of textured structures; a plurality of beads disposed inside the textured structures; and a second coating layer disposed over the first coating layer.

The arithmetic mean height of the textured structures may be lower than a reference height.

The height distribution of the textured structures may be 3 or less.

The maximum height of the textured structures may be greater than or equal to 2.0 micrometers.

The diameter of the beads may be between greater between 0.8 micrometers and 3.5 micrometers.

The first refractive index of the first coating layer, the second refractive index of the beads, and the third refractive index of the second coating layer may be the same.

Each of the first refractive index, the second refractive index, and the third refractive index may be between 1.49 and 1.65.

The base film may be made of polyethylene terephthalate.

The above description has been presented to enable any person skilled in the art to make and use the technical idea of the present invention, and has been provided in the context of a particular application and its requirements. Various modifications, additions and substitutions to the described embodiments will be readily apparent to those skilled in the art, and the general principles defined herein may be applied to other embodiments and applications without departing from the scope of the present invention. The above description and the accompanying drawings provide an example of the technical idea of the present invention for illustrative purposes only. That is, the disclosed embodiments are intended to illustrate the scope of the technical idea of the present invention.

## Claims

1. A display device comprising:
a display panel (110); and
a plurality of subpixels (SP) arranged on the display panel (110),
an antiglare layer (700) disposed over the display panel (100), wherein the antiglare layer (700) comprises:
a base film (SF);
a first coating layer (CTL1) disposed over the base film (SF) and comprising a plurality of textured structures;
a plurality of beads (BD) disposed inside the textured structures; and
a second coating layer (CTL2) disposed over the first coating layer (CTL1).

2. The display device of claim 1, wherein an arithmetic mean height of the textured structures is lower than a reference height.

3. The display device of claim 1 or 2, wherein a height distribution of the textured structures is 3 or less, preferably a maximum height of the textured structures is greater than or equal to 2.0 micrometers.

4. The display device of any one of the preceding claims, wherein a diameter of the beads (BD) is between greater between 0.8 micrometers and 3.5 micrometers.

5. The display device of any one of the preceding claims, wherein a first refractive index of the first coating layer (CTL1), a second refractive index of the beads (BD), and a third refractive index of the second coating layer (CTL2) are the same.

6. The display device of claim 5, wherein each of the first refractive index, the second refractive index, and the third refractive index is between 1.49 and 1.65.

7. The display device of any one of the preceding claims 5 or 6, wherein the first refractive index of the first coating layer (CTL1) is the same as the second refractive index of the plurality of beads (BD).

8. The display device of any one of the preceding claims 5, 6 or 7, wherein the second coating layer (CTL2) includes a first portion having a third refractive index that is the same as the first refractive index, and a second portion having a fourth refractive index that is smaller than the third refractive index.

9. The display device of any one of the preceding claims, wherein the plurality of textured structures of the first coating layer (CTL1) penetrate the second coating layer (CTL2).

10. The display device of any one of the preceding claims, the height of the end portions of the plurality of textured structures of the first coating layer (CTL1) is higher than the height of the upper surface of the second coating layer (CTL2).

11. The display device of any one of the preceding claims, wherein the area of the upper surface of the second coating layer (CTL2) is wider than the area of the lower surface of the second coating layer (CTL2).

12. The display device of any one of the preceding claims, wherein the shape of the plurality of uneven portions is a cone shape.

13. The display device of any one of the preceding claims, light emitted from a plurality of sub-pixels (SP) is emitted to the outside through the plurality of beads (BD) included inside the plurality of uneven portions.

14. The display device of any one of the preceding claims, wherein the base film (SF) comprises polyethylene terephthalate.

15. The display device of any one of the preceding claims, the display device further comprising a polarizing plate (330) disposed between the display panel (110) and the antiglare layer (700).
